Europäisches Patentamt

European Patent Office

Office européen des brevets

(11) Publication number: **0 209 109 B1**

(19)

(12) **EUROPEAN PATENT SPECIFICATION**

(45) Date of publication of patent specification: **25.03.92**  (51) Int. Cl.⁵: **C23C  16/50**

(21) Application number: **86109658.4**

(22) Date of filing: **14.07.86**

The file contains technical information submitted after the application was filed and not included in this specification

(54) Method of and apparatus for forming film by utilizing low-temperature plasma.

(30) Priority: **15.07.85 JP 154298/85**

(43) Date of publication of application:
**21.01.87 Bulletin  87/04**

(45) Publication of the grant of the patent:
**25.03.92 Bulletin  92/13**

(84) Designated Contracting States:
**FR GB**

(56) References cited:
**DE-A- 3 144 016**

**PATENT ABSTRACTS OF JAPAN, vol. 7, no.
144 (E-183)[1289], 23rd June 1983; & JP-A-58
56 325 (FUJITSU K.K.) 04-04-1983**

(73) Proprietor: **HITACHI, LTD.**
**6, Kanda Surugadai 4-chome
Chiyoda-ku, Tokyo 100(JP)**

Proprietor: **HITACHI ENGINEERING AND SER-
VICES CO., LTD.**
**2-2 Saiwaicho-3-chome
Hitachi-shi(JP)**

(72) Inventor: **Sonobe, Tadasi**
**1-1, Sekidanishi-1-chome
Nakosomachi Iwaki-shi(JP)**
Inventor: **Suzuki, Noboru**
**29-21, Nishinarusawacho-2-chome
Hitachi-shi(JP)**
Inventor: **Chiba, Kiyosi**
**7-9, Jonancho-2-chome
Hitachi-shi(JP)**
Inventor: **Suzuki, Kazuo**
**5-4, Sukegawacho-2-chome
Hitachi-shi(JP)**
Inventor: **Nakatani, Mitsuo**
**70-17-317, Nasecho
Totsuka-ku Yokohama(JP)**
Inventor: **Watanabe, Takeshi**
**1208, Shimokuratacho
Totsuka-ku Yokohama(JP)**
Inventor: **Ishigaki, Yukio**
**24-5, Osecho-3-chome
Hitachi-shi(JP)**

(74) Representative: **Strehl, Schübel-Hopf, Groen-
ing**
**Maximilianstrasse 54 Postfach 22 14 55
W-8000 München 22(DE)**

## Description

### BACKGROUND OF THE INVENTION

The present invention relates to a method of and an apparatus for forming a film by utilizing low-temperature plasma, and more particularly to a film formation apparatus which utilizes low-temperature plasma and is suited to form an inter-layer insulating film necessary for integrated circuits such as an LSI (namely, a large scale integration circuit) to have a multi-layer structure.

In a film formation apparatus which utilizes low-temperature plasma to grow an insulating film on a flat substrate such as an LSI substrate, the substrate is kept at a relatively low-temperature to improve the quality of the grown film, and the acceleration of ions is made as little as possible to prevent the degradation of the film due to ion bombardment. However, when an LSI includes a multi-layered wiring structure, a wiring pattern is formed, as a protrusion, on an underlying layer and thus a groove is formed between adjacent wiring conductors. It is desirable that the groove is filled with an inter-layer insulating film grown on the wiring conductors, and moreover the inter-layer insulating film has a flat surface. In a conventional film formation apparatus utilizing low-temperature plasma, however, an inter-layer insulating film having an uneven surface is formed, and moreover a coarse film may be formed on the above groove.

The construction and operation of the conventional film formation apparatus will be explained below, by reference to the drawings.

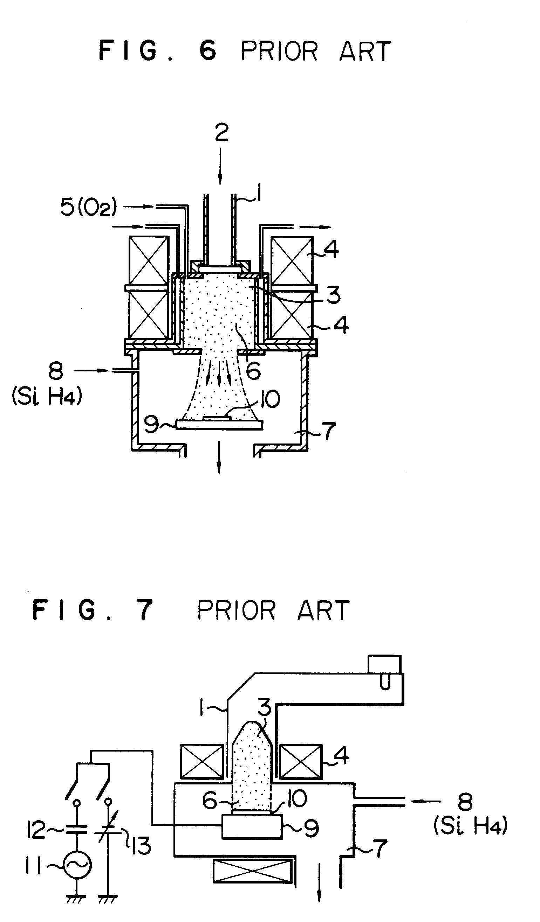

Fig. 6 shows a conventional ECR-type (electron cyclotron resonance-type) film formation apparatus which utilizes low-temperature plasma generated in electron cyclotron resonance conditions, as disclosed in U.S. Patent 4,401,054 issued on August 30, 1983. Referring to Fig. 6, microwaves 2 are introduced into a plasma formation chamber 3 which is provided in a central portion of the film formation apparatus, through a waveguide 1. When the frequency of the microwaves 2 agrees with the frequency of the cyclotron motion of electron due to the magnetic field generated by a magnetic coil 4, electron cyclotron resonance occurs, and plasma 6 is generated in the plasma formation chamber 3 on the basis of the collision of electrons with a gas 5 (for example, $O_2$) introduced into the chamber 3. The plasma 6 thus generated is introduced into a specimen chamber 7 by the intensity gradient of the magnetic field generated by the magnetic coil 4, and activates a film material gas 8 (for example, $SiH_4$) introduced into the specimen chamber 7, to grow an insulating film (for example, an $SiO_2$ film) on the surface of a specimen 10, such as a silicon substrate, which is placed on a specimen table 9.

In this case, the kinetic energy of ions contained in the plasma 6 which has been extracted into the specimen chamber 7, is made low so as not to damage the surface of the grown film by ion bombardment.

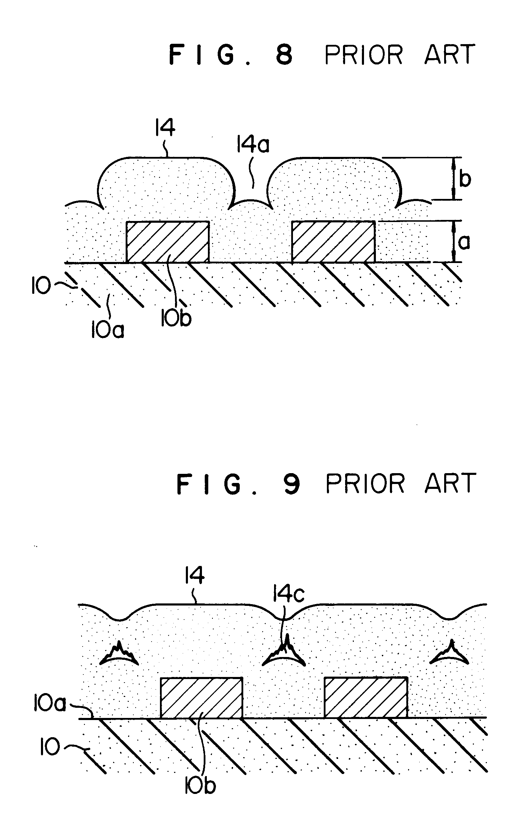

Fig. 7 shows another conventional ECR-type film formation apparatus which utilizes low-temperature plasma generated in electron cyclotron resonance conditions. This type of apparatus is disclosed in Japanese Patent Unexamined Publication No. 59-3018 published January 9, 1984. This apparatus is different from the apparatus for Fig. 6 in that a variable voltage dc power source 13 and an RF power source 11 are selectively connected to the specimen table 9 in such a manner that the RF power 11 is applied through a capacitor 12 to the specimen table 13 for preventing the specimen table from being electrically charged and the dc power 13 is applied, simultaneously or instead of the RF power, to the specimen table for controlling the energy of ions incident upon the specimen 10. When an insulating film is grown on the specimen 10 by these film formation apparatuses, the insulating film will have such a cross section as shown in Fig. 8. That is, owing to the presence of wiring conductors 10b on a surface of a substrate 10a, a groove 14a having the depth b nearly equal to the thickness a of the wiring conductors 10b will be formed in the surface of an insulating film 14. When the film 14 is further grown to make flat the surface thereof, the surface of the grown film becomes smooth but a vacancy 14c is formed in such a thick film at a position over a groove between adjacent wiring conductors, as shown in Fig. 9. That is, it is impossible to grow a uniform film all over the surface of the substrate.

DE-A-3 144 016 discloses a film forming apparatus and method. This known apparatus includes a grid electrode in the form of a mesh or cylinder disposed in the specimen chamber between a plasma extracting aperture and the specimen. While the cylindrical electrode is said to increase the uniformity of the reactions at the surface of the specimen, in particular along the periphery thereof, projecting portions as usually exist on a substrate surface to be coated with a film will result in a correspondingly uneven film surface.

### SUMMARY OF THE INVENTION

It is an object of the present invention to form a thin and uniform film having a flat surface on the whole area of a specimen, even when the surface of the specimen is uneven.

The invention meets this object by the apparatus and method as claimed in claims 1 and 3, respectively. The invention utilizes the low-temperature plasma not only for activating a film material gas to form the film on the specimen but also for scraping the film surface by bombardment with ions contained in the plasma, which two actions may take place either simultaneously or alternately, depending on the potential controlling the plasma and the supply of the film material gas.

BRIEF DESCRIPTION OF THE DRAWINGS

Fig. 1 is a schematic diagram showing the cross section and circuit configuration of an embodiment of a film formation apparatus which utilizes low-temperature plasma in accordance with the present invention.

Figs. 2 and 3 are sectional diagrams for explaining the film-surface smoothing action of incident ions.

Fig. 4 is a sectional diagram showing another embodiment of a film formation apparatus which utilizes low-temperature plasma in accordance with the present invention.

Fig. 5 is a schematic diagram showing a further embodiment of a film formation apparatus which utilizes low-temperature plasma in accordance with the present invention.

Fig. 6 is a sectional diagram showing an example of a conventional film formation apparatus utilizing low-temperature plasma.

Fig. 7 is a schematic diagram showing another example of a conventional film formation apparatus utilizing low-temperature plasma.

Figs. 8 and 9 are sectional diagrams showing films which are formed by the film formation apparatuses of Figs. 6 and 7.

Fig. 10 shows a film forming process by using an apparatus of the present invention as compared with that by using a conventional apparatus.

DESCRIPTION OF THE PREFERRED EMBODIMENTS

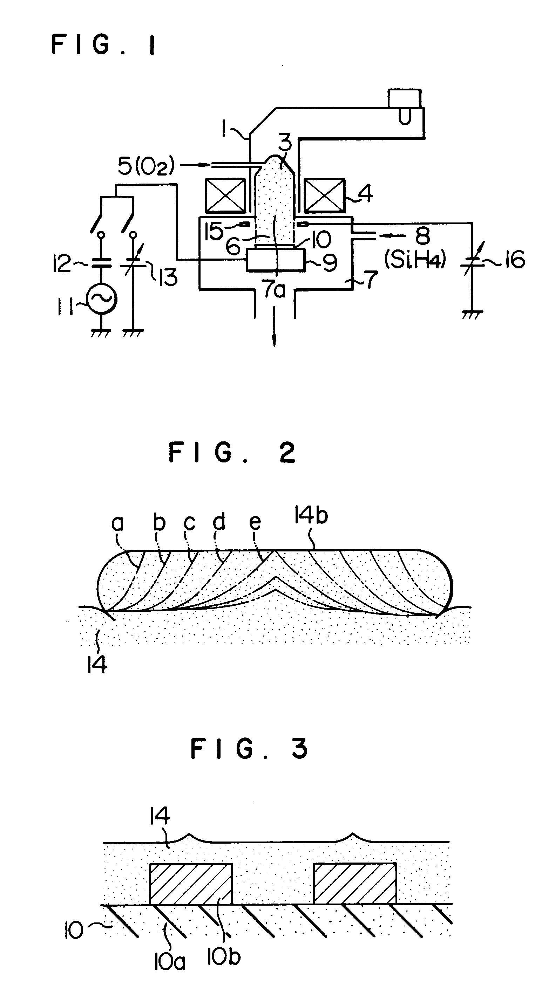

The present invention will be explained below, by reference to Figs. 1 to 5 and 10.

Fig. 1 shows an embodiment of a film formation apparatus according to the present invention, which is an improvement of the conventional film formation apparatus shown in Fig. 7. This embodiment is different from the conventional apparatus of Fig. 7 in that a ring-shaped grid electrode 15 is disposed in the specimen chamber 7 at a position just under a plasma extracting aperture 7a which is provided at the boundary between the plasma formation chamber 3 and the specimen chamber 7, and the grid electrode 15 is applied with a bias potential from a variable power source 16. Explanation of common parts which are designated by the same reference numerals as those in Figs. 1 and 7, will be omitted for the sake of brevity.

Now, the operation of the present embodiment will be explained below. When an insulating film is grown on the surface of the specimen 10 in a state that the bias potential is not applied to the grid electrode 15, the grown film 14 will have such a cross section as shown in Fig. 8. Thereafter, the supply of the film material gas 8 into the specimen chamber 7 is stopped, and a bias potential is applied to the grid electrode 15 so that ions contained in the plasma 6 which has been extracted from the plasma formation chamber 3 into the specimen chamber 7, are accelerated in directions toward the specimen 10. At this time, the moving direction of accelerated ions is oblique with respect to the side face or shoulder of a protrusion 14b on the grown film 14. Accordingly, the side of the protrusion 14b is seraped by ion bombardment progressively upto the boundaries shown by a, b, c, d, e and so on in Fig. 2, and finally the surface of the insulating film 14 becomes substantially flat as shown in Fig. 3.

In the above explanation, after the insulating film has been grown on the surface of the specimen, the protrusion on the grown film is scraped to make the surface of the grown film flat. However, the processing for forming a film having a flat surface on the uneven surface of the specimen is not limited to the above processing, but an appropriate bias potential may be applied to the grid electrode 15 during a period when the film is grown on the surface of the specimen, in order for the film forming action and protrusion scraping action of ions to be simultaneously performed. In this case, the insulating film 14 having a flat surface can be obtained by a single process, and thus the control operation for forming a desired film will be simple. Alternatively, the potential of the grid electrode may be varied so that the film forming action and the protrusion scraping action are alternately and repeatedly performed in a period when the film 14 is grown on the specimen, to make uniform the grown film and to make flat the surface thereof.

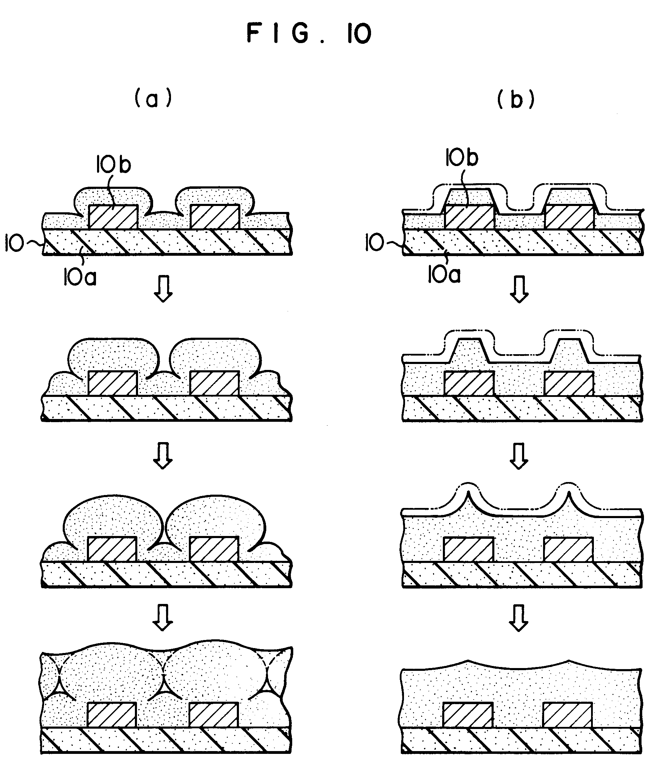

At (b) of Fig. 10 is shown the film forming process of the present embodiment for a case where the film forming action and protrusion scraping action of incident ions are simultaneously performed, and at (a) of Fig. 10 is shown the film forming process of the conventional film formation apparatus of Fig. 6 or 7, for the sake of comparison. The insulating film formed by the conventional apparatus has a flat surface after the thickness of the film has become considerably large, as shown in part (a) of Fig. 10. While, the insulating film formed by the present embodiment has a flat surface even when the thickness of the film is small, as shown in part (b) of Fig. 10. Fig. 10 also shows the following facts. That is, when an insulating film is grown on a substrate having a wiring pattern thereon by the conventional apparatus, a coarse film may be formed over a groove between adjacent wiring conductors. When an insulating film is grown on the above substrate by the present embodiment, the grown film is uniform all over the surface of the substrate.

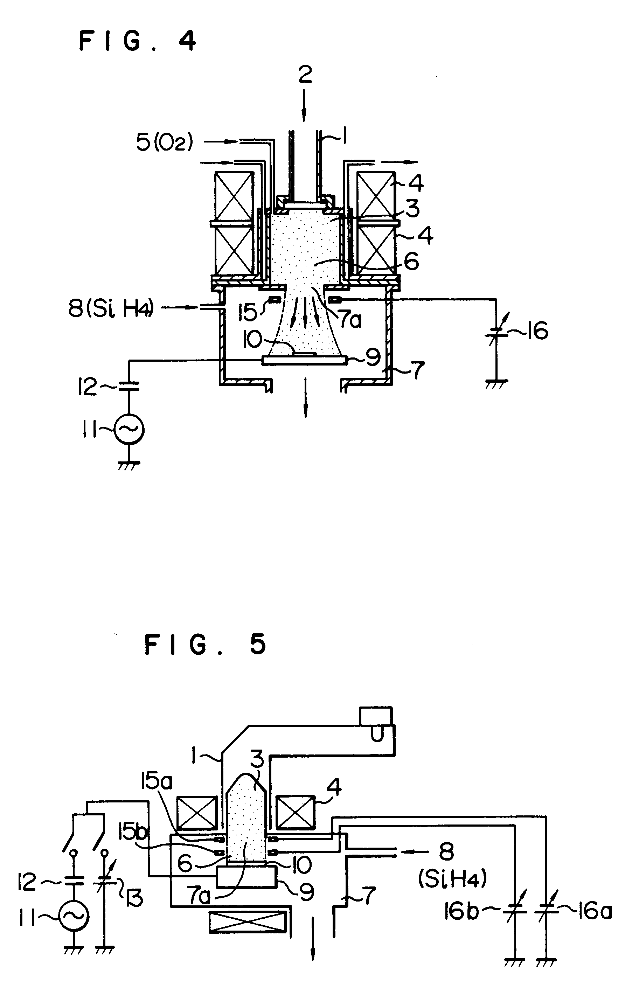

Fig. 4 shows another embodiment of a film formation apparatus which utilizes low-temperature plasma in accordance with the present invention. This embodiment is an improvement of the conventional film formation apparatus of Fig. 6 and is different therefrom in that the grid electrode 15 is disposed just under the plasma extracting aperture 7a and the potential of the grid electrode 15 is controlled by the variable power source 16.

Fig. 5 shows a further embodiment of a film formation apparatus which utilizes low-temperature plasma in accordance with the present invention. This embodiment is basically the same as the conventional apparatus of Fig. 7, excepting that a plurality of grid electrodes 15a and 15b are disposed just under the plasma extracting aperture 7a so as to form a multi-stage grid electrode, and the grid electrodes 15a and 15b are connected to the variable power sources 16a and 16b, respectively, to control the potentials of the grid electrodes 15a and 15b independently of each other. In the embodiments of Figs. 4 and 5, the film forming action and protrusion scraping action of ions can be performed as in the embodiment of Fig. 1.

As has been explained in the foregoing, according to the present invention, the kinetic energy of ions incident upon a specimen is controlled so that the protrusion on a grown film is scraped by incident ions. Accordingly, even when the surface of the specimen is made uneven by a wiring pattern or others, a film having a flat surface can be formed on the uneven surface of the specimen, and the film is uniform all over the surface of the specimen without containing a coarse portion, which is apt to appear over a groove between adjacent wiring conductors when the film is formed by one of the conventional film formation apparatuses. Further, according to the present invention, even a thin film formed on the specimen is uniform and has a flat surface.

## Claims

1. A film formation apparatus including
   a plasma formation chamber (3) for generating a low-temperature plasma (6),
   a specimen chamber (7) communicating with the plasma formation chamber (3) through a plasma extracting aperture (7a),
   a specimen table (9) disposed in the specimen chamber (7) for supporting a specimen (10),

means for introducing a film forming gas (8) directly into the specimen chamber (7), said gas being activated by the plasma (6) to form a film (14) on the specimen (10),
   characterized in
   that a ring-shaped grid electrode (15) is disposed between said aperture (7a) and said table (9), and
   that control means (16) are provided for applying a potential to said electrode (15), said control means (16) being adapted to selectively control said potential for scraping part of said film (14) by ions contained in the plasma (6).

2. The apparatus of claim 1, wherein a plurality of ringshaped electrodes (15a, 15b) are disposed to form a multistage grid electrode along the direction in which the plasma (6) is extracted from the plasma formation chamber (3).

3. A method of forming a film (14) on a specimen (10) disposed in a specimen chamber (7) by introducing a film forming gas (8) directly into said chamber (7) and activating said gas (8) by a low-temperature plasma (6) introduced into said chamber (7) through an aperture (7a),
   characterized in that a variable potential is applied to a ring-shaped grid electrode (15) disposed between said aperture (7a) and said specimen (10) while the film (14) is formed on the specimen (10) or subsequently while the supply of film forming gas (8) is stopped, said potential being selectively controlled for scraping part of the film (14) by ions contained in the plasma (6).

4. The method of claim 3, wherein the potential applied to said electrode (15) is controlled in such a manner
   that zero bias potential is applied to said electrode (15) while a film (14) is formed on the specimen (10), and
   that a predetermined bias voltage is applied to the electrode (15) to scrape part of the film (14) by ions contained in the plasma (6), while the supply of film forming gas (8) into said chamber (7) is stopped.

## Revendications

1. Dispositif pour former une pellicule, comprenant
   une chambre (3) de formation d'un plasma, pour produire un plasma à basse température (6),
   une chambre à échantillon (7) communiquant avec la chambre (3) de formation du plasma, par l'intermédiaire d'une ouverture (7a) d'extraction du plasma,

une table porte-échantillon (9) disposée dans la chambre à échantillon (7) de manière à supporter un échantillon (10),

des moyens pour introduire un gaz (8) de formation d'une pellicule, dirèctement dans la chambre à échantillon (7), ledit gaz étant activé par le plasma (6) de manière à former une pellicule (14) sur l'échantillon (10), caractérisé en ce

qu une électrode de grille de forme annulaire (15) est disposée entre ladite ouverture (7a) et ladite table (9), et

que des moyens de commande (16) sont prévus pour appliquer un potentiel à ladite électrode (15), lesdits moyens de commande (16) étant adaptés de manière à commander de façon sélective ledit potentiel pour retirer une partie de ladite pellicule (14) au moyen d'ions contenus dans le plasma (6).

2. Dispositif selon la revendication 1, dans lequel une pluralité d'électrodes de forme annulaire (15a,15b) sont disposées de manière à former une électrode de grille à étages multiples, dans la direction dans laquelle le plasma (6) est extrait de la chambre (3) de formation du plasma.

3. Procédé pour former une pellicule (14) sur un échantillon (10) disposé dans une chambre à échantillon (7), par introduction d'un gaz (8) formant la pellicule, directement dans ladite chambre (7) et activation dudit gaz (8) par un plasma à basse température (6) introduit dans ladite chambre (7) par une ouverture (7a),

caractérisé en ce qu un potentiel variable est appliqué à une électrode de grille de forme annulaire (15) disposée entre ladite ouverture (7a) et ledit échantillon (10), alors que la pellicule (14) est formée sur l'échantillon (10), ou ultérieurement alors que l'envoi du gaz (8) formant la pellicule est arrêté, ledit potentiel étant commandé de façon sélective pour retirer une partie de la pellicule (14) au moyen d'ions contenus dans le plasma (6).

4. Procédé selon la revendication 3, selon lequel le potentiel appliqué à ladite électrode (15) est commandé de telle sorte

qu un potentiel de polarisation nul est appliqué à ladite électrode (15) alors qu'une pellicule (14) est formée sur l'échantillon (10), et

qu une tension de polarisation prédéterminée est appliquée à l'électrode (15) de manière à éliminer une partie de la pellicule (14) par des ions contenus dans le plasma (6), alors que l'envoi du gaz (8), formant la pellicule, dans ladite chambre (7) est arrêté.

## Patentansprüche

1. Gerät zur Schichtbildung, umfassend
eine Plasma-Erzeugungskammer (3) zur Erzeugung eines Tieftemperaturplasmas (6),
eine Probenkammer (7), die mit der Plasma-Erzeugungskammer (3) über eine Plasma-Ausziehöffnung (7a) in Verbindung steht,
einen in der Probenkammer (7) angeordneten Probentisch (9) zur Halterung einer Probe (10), und
eine Einrichtung zum Einleiten eines schichtbildenden Gases (8) direkt in die Probenkammer (7), wobei das Gas durch das Plasma (6) zur Ausbildung einer Schicht (14) auf der Probe (10) aktiviert wird,
dadurch gekennzeichnet,
daß zwischen der Öffnung (7a) und dem Tisch (9) eine ringförmige Gitterelektrode (15) angeordnet ist, und
daß zum Anlegen eines Potentials an die Elektrode (15) eine Steuereinrichtung (16) vorgesehen ist, die eine selektive Steuerung des Potentials derart gestattet, daß ein Teil der Schicht (13) durch in dem Plasma (6) enthaltene Ionen abgeschabt wird.

2. Gerät nach Anspruch 1, wobei mehrere ringförmige Elektroden (15a, 15b) zur Bildung einer mehrstufigen Gitterelektrode längs der Richtung angeordnet sind, in der das Plasma (6) aus der Plasma-Erzeugungskammer (3) ausgezogen wird.

3. Verfahren zum Ausbilden einer Schicht (14) auf einer in einer Probenkammer (7) angeordneten Probe (10) durch Einleiten eines schichtbildenden Gases (8) direkt in die Kammer (7) und Aktivieren des Gases (8) durch ein in die Kammer (7) durch eine Öffnung (7a) eingeleitetes Tieftemperaturplasma (6),

dadurch gekennzeichnet, daß an eine zwischen der Öffnung (7a) und der Probe (10) angeordnete ringförmige Gitterelektrode (15) ein variables Potential angelegt wird, während die Schicht (14) auf der Probe (10) gebildet wird oder anschließend während die Zufuhr des schichtbildenden Gases (8) unterbrochen ist, wobei das Potential selektiv so gesteuert wird, daß ein Teil der Schicht (14) durch in dem Plasma (6) enthaltene Ionen abgeschabt wird.

4. Verfahren nach Anspruch 3, wobei das an die Elektrode (15) angelegte Potential so gesteuert wird,

daß an die Elektrode (15) ein Null-Vorspannungspotential angelegt wird, während die Schicht (14) auf der Probe (10) ausgebildet wird, und

daß an die Elektrode (15) eine vorbestimmte Spannung angelegt wird, um einen Teil der Schicht (14) durch in dem Plasma (6) enthaltene Ionen abzuschaben, während die Zufuhr von schichtbildendem Gas (8) in die Kammer (7) unterbrochen ist.

FIG. 1

FIG. 2

FIG. 3

FIG. 4

FIG. 5

# FIG. 6 PRIOR ART

# FIG. 7 PRIOR ART

## F I G . 8 PRIOR ART

## F I G . 9 PRIOR ART

# F I G . 10

(a)

(b)